# EUROPÄISCHE PATENTSCHRIFT

(11) **EP 0 659 286 B1**
(45) Veröffentlichungstag und Bekanntmachung des Hinweises auf die Patenterteilung: **29.10.1997**
(21) Anmeldenummer: 93919305.8
(22) Anmeldetag: 09.09.1993
(51) Int. Cl.: G03F 7/039, C08F 265/06

(54) **VERWENDUNG EINES GIESSHARZES UND VERFAHREN ZU DESSEN HERSTELLUNG**
USE OF A CASTING RESIN AND PROCESS FOR PRODUCING THE SAME
UTILISATION D'UNE RESINE DE COULEE ET SON PROCEDE DE FABRICATION

(30) Priorität: 10.09.1992 DE 4230297
(43) Veröffentlichungstag der Anmeldung: 28.06.1995
(73) Patentinhaber: Forschungszentrum Karlsruhe GmbH, 76133 Karlsruhe (DE); Röhm GmbH, 64293 Darmstadt (DE)
(72) Erfinder: EL-KHOLI, Aida, D-76344 Eggenstein-Leopoldshafen (DE); GÖTTERT, Jost, D-53426 Schalkenbach (DE); MOHR, Jürgen, D-75056 Sulzfeld (DE); KRIEG, Manfred, D-64289 Darmstadt (DE)
(74) Vertreter: Rückert, Friedrich, Dr.
(86) Internationale Anmeldenummer: EP9302435
(87) Internationale Veröffentlichungsnummer: WO9406058

(56) Entgegenhaltungen:
- EP-A- 0 051 166
- EP-A- 0 110 515
- EP-A- 0 278 059
- WO-A-91/04511
- DE-C- 675 808
- DE-C- 1 068 467
- PATENT ABSTRACTS OF JAPAN vol. 7, no. 57 (P-181)(1202) 9. März 1983 & JP,A,57 204 033 (TOKYO SHIBAURA DENKI K.K.) 14. Dezember 1982
- DATABASE WPI Derwent Publications Ltd., London, GB; AN 88-295422 & JP,A,63 214 704 (FUJIKURA CABLE WORKS KK)
- DATABASE WPI Derwent Publications Ltd., London, GB; AN 92-254398 & JP,A,4 171 452 (DAIKON KOGYO KK) 18. Juni 1992

## Beschreibung

Die Erfindung betrifft die Verwendung eines Gießharzes und ein Verfahren zu dessen Herstellung gemäß Anspruch 1 und dem Oberbegriff von Anspruch 4.

Die Verwendung von Gießharzen und derartiges Verfahren sind aus dem Bericht Nr. 4267 des Kernforschungszentrums Karlsruhe, mit dem Titel "Untersuchungen zur Herstellung von galvanisierbaren Mikrostrukturen mit extremer Strukturhöhe durch Abformung mit Kunststoff im Vakuum-Reaktionsgießverfahren" der Autoren H. Vollmer, W. Ehrfeld, P. Hagmann (Mai 1987) bekannt. Gebräuchliche Gießharze werden im Kapitel "3.3 Formmassen" beschrieben.

Bei der Röntgentiefenlithographie wird ein Röntgenresist, der auf eine Grundplatte aufpolymerisiert ist, über eine Maske mit Röntgenlicht bestrahlt, wonach die bestrahlten Bereiche mit einem der bekannten Entwickler herausgelöst werden. Hierdurch werden plattenartige Körper hergestellt, deren Resistmaterial mikrostrukturiert ist.

Als Entwickler wird bevorzugt das in der DE 30 39 110 Al beschriebene Gemisch aus Wasser, einem Glycoläther, einem Amin und einem Azin verwendet.

Als Röntgenresistmaterial hat sich, wie aus dem oben genannten Bericht hervorgeht, wegen des erzielbaren Kontrastes Polymethylmethacrylat (PMMA) bewährt. PMMA-Schichten lassen sich durch radikalische Polymerisation eines Gießharzes in Schichten von wenigen Mikrometern bis zu über einem Millimeter auf metallischen Grundplatten direkt herstellen.

Üblicherweise wird zur Herstellung von Resistschichten das kommerziell erhältliche PMMA-Gießharz Plexit M60^{R} verwendet, mit dem im allgemeinen zufriedenstellende Ergebnisse erzielt werden.

In der Veröffentlichung "Molding of Threedimensional Microstructures by the LIGA-Process" von M. Harmening et al. in den Proceedings der Tagung Micro Electro Mechanical Systems '92, Travemünde, 4. bis 7. Februar 1992 werden der Röntgentiefenlithographieprozeß und seine Randbedinungen am Beispiel des üblicherweise verwendeten PMMA-Gießharzes beschrieben.

Die bekannten Gießharze werden üblicherweise mit dem Initiator Benzoylperoxid (BPO) ca. 1,5 Gew.-%) und Dimethylanilin (DMA) (1 Gew.-%) kalt gehärtet, wobei sich der Röntgenresist bildet.

Gemäß der JP-A-57204033 wird auf einem Silicium-Substrat ein Oxidfilm aufgebracht, der nachfolgend bereichsweise geätzt wird, so daß aus dem Oxidfilm ein Muster gebildet wird. Das Ätzen erfolgt durch eine Maske, die aus einem Resist besteht. Die Maske wird hergestellt durch Auftragen einer Lösung von Polymethylmethacrylat und Methylmethyacrylat auf dem Oxidfilm, Aushärten der Lösung zu einem Resist, bildmäßiger Bestrahlung des Resists durch Elektronenstrahlen und Entwickeln, so daß die Maske das gewünschte Muster bildet.

Gegenstand der JP-A-4171452 ist ein Resist für hochenergetische Strahlung, der aus einem Copolymer aus 80-60 mol-% Tetrafluoropropylmethacrylat und 20-40 mol-% Methacrylsäure besteht. Die Herstellung des Copolymers erfolgt gemäß einem Beispiel mit Hilfe von 0.04 Gew.-% Azodiisobuttersäuredinitril (AIBN) und 0,06 Gew.-% Laurylmercaptan.

Die DE-C-675808 bezieht sich auf die Herstellung von als Glasersatz (organisches Glas) verwendbaren Polymerisaten von Homologen der Acrylsäure oder ihrer Derivate. Die Herstellung erfolgt in der Weise, daß die Polymerisation der monomeren Ausgangsstoffe in Gegenwart von bereits polymerisierten Verbindungen aus den gleichen Monomeren bei niedrigen Temperaturen unter Anwendung geringer Mengen von Katalysatoren durchgeführt wird.

Weiterführende Untersuchungen haben ergeben, daß der Feststoffanteil dieses Gießharzes, der an der Polymerisation des Gießharzes nicht teilnimmt, ein mittleres Molekulargewicht von etwa 90000 und eine untere Molekulargewichtsgrenze von ca. 5000 besitzt. Nach der Kalthärtung stellt sich ein Gewichtsmittel im Resist von ca. 600000 ein. Auch hier beträgt die untere Molekulargewichtsgrenze ca. 5000.

Die bekannten Gießharze werden üblicherweise mit dem Initiator Benzoylperoxid (BPO) ca. 1,5 Gew.-%) und Dimethylanilin (DMA) (1 Gew.-%) kalt gehärtet, wobei sich der Röntgenresist bildet. Die untere Molekulargewichtsgrenze bei Plexit M60^{R} wird durch den Feststoffanteil bestimmt und verändert sich bei der Kalthärtung nicht mehr.

Derzeit wird üblicherweise in der Tiefe eine Röntgen-Dosis von 4kJ/cm³ abgelagert, während die Oberflächendosis bei maximal 20 kJ/cm³ gehalten wird. Für diesen Fall wurde gefunden, daß sich in den bestrahlten Bezirken im Standard-Gießharz eine Molekulargewichtsverteilung mit einem Gewichtsmittel von ca. 6000 und einer Streuung im Bereich von 500 und 50000 einstellt.

Sämtliche hier genannten Molekulargewichte wurden mit der "Gel Permeations Chromatorgraphie (GPC)" Methode bestimmt (vgl. H.F. Mark et al. Encyclopedia of Polymer Science & Technology, Vol. 10, pp. 1-19, J. Wiley 1987).

Besonders bei der Herstellung von Mikrostrukturen mit hohem Aspektverhältnis (dem Verhältnis aus Höhe und Dicke der einzelnen Mikrostrukturkörper) und bei der hierdurch bedingten langen Entwicklungszeit stellt man bei Verwendung des Standard-Gießharzes häufig unlösliche Rück-stände fest. Außerdem ist die Qualität der Mikrostrukturen beeinträchtigt.

Der Erfindung liegt deshalb die Aufgabe zugrunde, ausgehend von diesen Untersuchungsergebnissen den bekannten und überwiegend verwendeten PMMA-Resist so zu modifizieren, daß die unbestrahlten Bereiche vom Entwickler nicht angegriffen werden können, andererseits die bestrahlten Bereiche des Resists bis zur minimal eingestrahlten Dosis vollständiger gelöst werden können.

Die Lösung der Aufgabe ergibt sich aus der Verwendung des Gießharzes gemäß Anspruch 1 und durch das Verfahren zu dessen Herstellung gemäß Anspruch 4. Die abhängigen Ansprüche beschreiben die Verwendung bevorzugter Gießharze und bevorzugte Weiterbildungen des Verfahrens.

Es hat sich als entscheidend herausgestellt, daß die untere Molekulargewichtsgrenze des PMMA-Feststoffs im Gießharz sowie im Polymerisat mindestens 30000, besser 40000 oder sogar 50000 beträgt. Wenn die untere Molekulargewichtsgrenze des PMMA-Feststoffs und des Polymerisats in der angegebenen Weise, insbesondere auf die beiden letztgenannten Werte, erhöht ist, kann auch bei höheren Temperaturen entwickelt werden, so daß die bestrahlten Bereiche vollständig gelöst werden, ohne daß sich Teile der unbestrahlten Bereiche lösen. Bei den bisher verwendeten PMMA-Resists ist eine höhere Entwicklungstemperatur nicht ohne Qualitätseinbuße möglich; hier hat sich die Entwicklungstemperatur von ca. 40 °C als geeignet erwiesen.

Das mittlere Molekulargewicht des PMMA-Feststoffs M_{w} soll den Wert 1,3 Millionen nicht übersteigen.

Durch den Anteil des PMMA-Feststoffs wird die Viskosität des Gießharzes bestimmt. Gießharze mit einer geeigneten Viskosität werden durch einen Feststoffanteil von 5 bis 35 Gew.-%, besser von 12 bis 19 Gew.-%, erhalten. Besonders bevorzugt wird ein Gießharz mit einem PMMA-Feststoffanteil von 14 bis 16 Gew.-%.

Die Dispersität der Molekulargewichtsverteilung [Definition: Dispersität D = M_{w}/Mₙ mit M_{w}: mittleres Molekulargewicht (Gewichtsmittel) und Mₙ: Zahlenmittel] sollte möglichst klein sein und vorzugsweise unter 3, besser unter 2 liegen.

Zur Herstellung des erfindungsgemäß verwendeten Gießharzes wird in einem ersten Schritt ein aus PMMA bestehender Feststoff hergestellt, indem Methylmethacrylat mit dem Initiator Azodiisobuttersäuredinitril (AIBN) in einer Konzentration von 0,2 bis 0,4 Gew.-% ohne Regler oder mit einem Regler bestehend aus einem Mercaptan oder einem Mercaptan-Derivat in einer Konzentration unterhalb von 0,1 Gew.-% polymerisiert wird. Durch den Regler kann die Dispersität beeinflußt werden. Die genauen Konzentrationen des Initiators und des Reglers hängen von der Art und der Konzentration des Reglers ab. Die erfindungsgemäß einzustellenden Molekulargewichtsparameter können prinzipiell ohne die Zugabe eines Reglers erreicht werden.

Die Polymerisation kann eine Substanzpolymerisation oder eine Suspensionspolymerisation sein. Suspensionspolymerisationen werden in Th. Völker, H. Rauch-Puntigam, Acryl- und Methacrylverbindungen, S. 208-216, Springer-Verlag (1967) beschrieben. Die Polymerisation von MMA kann z.B. in einem Folienbeutel (Hostaphen^{R} etc.) im Wasserbad in Anlehnung an die BE 695 347 durchgeführt werden.

Als Regler sind Ethylmercaptoacetat {HS-CH₂-C(=O)-O-CH₂-CH₃} und insbesondere t-Butylmercaptan in einer Konzentration von 0,05 Gew.-% besonders geeignet. In jedem Fall muß die Konzentration des Reglers unter 0,1 Gew.-% liegen.

Das Gießharz wird hergestellt, indem 5 bis 35 Gew.-% des auf diese Weise hergestellten Feststoffs in der entsprechenden Menge MMA aufgelöst werden. Dieses Gießharz wird vorzugsweise in einer dünnen, wenige Mikrometer bis zu 1 - 2 Millimeter dicken Schicht auf einer Grundplatte direkt aufpolymerisiert. Die Schichtdicke richtet sich nach der beabsichtigten Art des Endprodukts; als Grundplatte wird vorzugsweise eine metallische Platte, z. B. aus vernickeltem Kupfer, verwendet, da eine solche Platte bei einem sich gegebenenfalls an die Herstellung der Mikrostrukturen aus PMMA anschließenden galvanischen Abformungsschritt als Kathode geschaltet werden kann.

Die Erfindung wird im folgenden anhand von Versuchsbeispielen und Figuren näher erläutert.

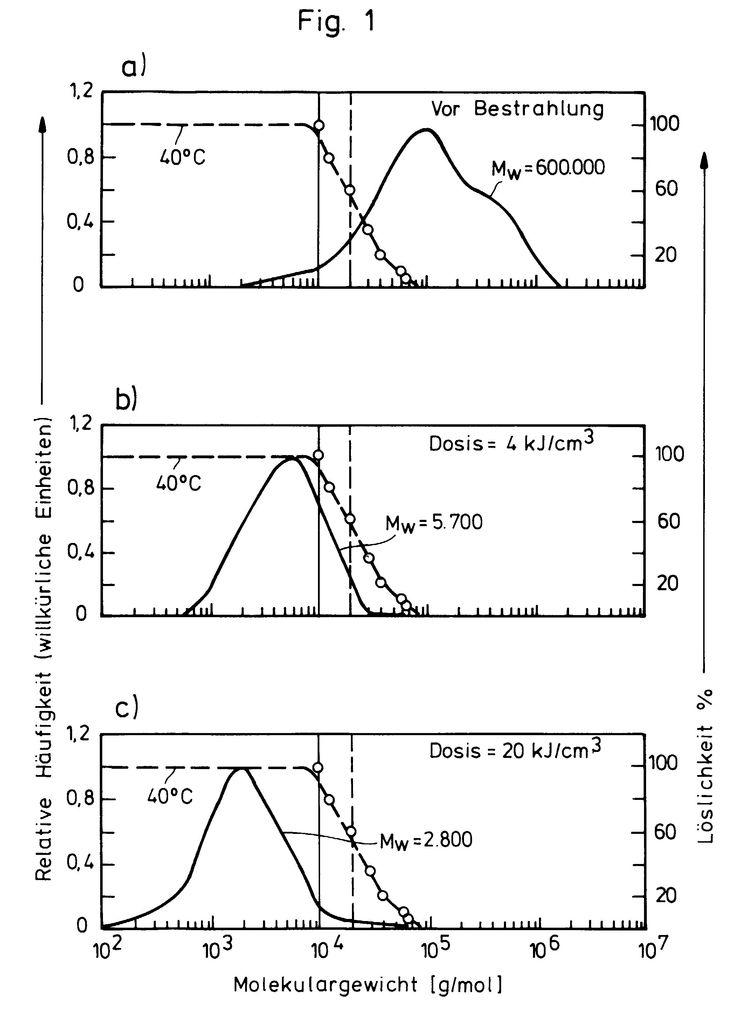

**Fig. 1** zeigt die Löslichkeit von PMMA in Abhängigkeit vom Molekulargewicht für eine Entwicklertemperatur von 40 °C. Im Teil a ist die Molekulargewichtsverteilung von Plexit M60^{R} vor der Bestrahlung, in Teil b nach einer Bestrahlung mit einer Dosis von 4 kJ/cm³ und in Teil c nach einer Bestrahlung mit einer Dosis von 20 kJ/cm³ aufgetragen.
In **Fig. 2** ist das Gewichtsmittel M_{w} des Feststoffs als Funktion der Konzentration des Initiators AIBN aufgetragen.
**Fig. 3** stellt das Gewichtsmittel und die untere Molekulargewichtsgrenze des Feststoffs als Funktion der Konzentration des Reglers Ethylmercaptoacetat für eine AIBN-Konzentration von 0,2 Gew.-% dar.
**Fig. 4** stellt das Gewichtsmittel und die untere Molekulargewichtsgrenze des Feststoffs als Funktion der Konzentration des Reglers t-Butylmercaptan für eine AIBN-Konzentration von 0,2 Gew.-% dar.
**Fig. 5** stellt das Gewichtsmittel und die untere Molekulargewichtsgrenze des Feststoffs als Funktion der Konzentration des Reglers Thiophenol für eine AIBN-Konzentration von 0,2 Gew.-% dar.
In **Fig. 6** ist das Gewichtsmittel des Feststoffs als Funktion der verschiedenen Reglerkonzentrationen für 0,2 Gew.-% des Initiators AIBN aufgetragen.
In **Fig. 7** ist die untere Molekulargewichtsgrenze des Feststoffs als Funktion der verschiedenen Reglerkonzentrationen für 0,2 Gew.-% des Initiators AIBN aufgetragen.
**Fig. 8** zeigt den Vergleich der Molekulargewichtsverteilungen des Polymerisats aus Plexit M60^{R} und einem erfindungsgemäß hergestellten Feststoff (GH-IMT 4) mit 1,5 Gew.-% BPO und 1 Gew.-% DMA polymerisiert.
**Fig. 9** zeigt schließlich die untere Molekulargewichtsgrenze für ds Polymerisat von Plexit M60^{R} und einem erfindungsgemäß hergestellten Feststoff (GH-IMT 4) mit 1,5 Gew.-% BPO und 1 Gew.-% DMA polymerisiert, als Funktion der BPO- und DMA-Konzentrationen.

### Beispiel 1: Herstellung des Feststoffanteils

Zur Darstellung des Feststoffanteils wird MMA mit dem Initiator Azodiisobuttersäuredinitril (AIBN) und teilweise mit den Reglern Thiophenol, t-Butylmercaptan sowie Ethylmercaptoacetat warm polymerisiert. Als Polymerisationskammer dient der Raum innerhalb eines viereckigen Dichtungsrings aus Ethylen-Propylen-Dien- Elastomer, der durch zwei Floatglasplatten abgedeckt wird. Dieser "Sandwich" wird mit Foldback-Klammern zusammengehalten. Zwischen einer der Floatglasplatten und dem Dichtungsring werden zwei Kanülen eingelegt, die zum Befüllen der Kammer mit dem flüssigen MMA/Initiator-Gemisch (ggf. mit Reglerzusatz) dienen und vor der Polymerisation entfernt werden. Die Floatglasplatten sind vor der Benutzung zuerst mit Wasser und dann mit Ethylacetat zu reinigen. Die Dichtungsringe werden aus 4 mm dicken Platten auf die gewünschten Maße zugeschnitten. Da die Platten Weichmachersubstanzen enthalten, sind die Dichtungen in Ethylacetat mindestens 3 h auszukochen und anschließend für ca. 2 h zu evakuieren. Das frisch angerührte MMA/Initiator-Gemisch (ggf. mit Reglerzusatz) wird unter Rühren auf 200 mbar evakuiert, um eventuell enthaltene Gase, die die Polymerisation inhibieren könnten, zu entfernen. Nach dem Abstellen des Rührers wird belüftet. Das Gemisch kann dann auf eine Spritze aufgezogen und über die eingelegten Kanülen in die Polymerisationskammer gefüllt werden. Es muß darauf geachtet werden, daß beim Befüllen der Kammer keine Luftblasen eingeschlossen werden. Die mit dem MMA/Initiator-Gemisch befüllte Kammer wird in einer Druckkammer auf eine Heizplatte gelegt. Die Druckkammer wird mit 10 bar Stickstoff befüllt, wodurch die Bilduung von Blasen in den polymerisierten Platten zuverlässig verhindert werden konnte. Zur Warmpolymerisation wird die Heizplatte mit 2 °C/h auf 65 °C erwärmt, 6 h bei dieser Temperatur gehalten und dann auf 125 °C erwärmt, wobei die Haltezeit dann 2 h beträgt. Anschließend wird mit 20 °C/h auf Raumtemperatur abgekühlt. Durch die Warmpolymerisation wird eine gegenüber der Kaltpolymerisation gleichmäßigere Molekulargewichtsverteilung erreicht.

### Beispiel 2: Einfluß der Initiatorkonzentration (AIBN) auf das Gewichtsmittel M_{w} und die Dispersität D des Feststoffs

MMA wurde mit verschiedenen Gew.-% AIBN ohne Reglerzusatz nach dem in Beispiel 1 beschriebenen Verfahren polymerisiert. Mit steigendem Initiatorgehalt werden das mittlere Molekulargewicht M_{w} und die untere Molekulargewichtsgrenze erniedrigt. Die Dispersitäten bewegen sich zwischen 2 und 5. Die untere Molekulargewichtsgrenze läßt sich bei einem Zusatz von 0,2 Gew.-% AIBN bis auf 45000 erhöhen. Wie Tabelle 1 zeigt, kann davon ausgegangen werden, daß bei AIBN-Konzentrationen von 0,2 bis 0,4 Gew.-% die untere Molekulargewichtsgrenze immer um 40000 liegt, während sich für AIBN-Konzentrationen über 1 Gew.-% um 10000 liegt.

**Tabelle 1:**

| Gewichtsmittel, Dispersität und untere Molekulargewichtsgrenze als Funktion der AIBN-Konzentration | | | |
|---|---|---|---|
| Gew.-% AIBN | M_{w} | Dispersität | untere Molekulargewichtsgrenze |
| 0,1 | 1693834 | 3,15 | 27000 |
| 0,2 | 1287600 | 2,56 | 45200 |
| 0,3 | 1274796 | 2,85 | 34000 |
| 0,4 | 1000553 | 2,26 | 40300 |
| 1,0 | 1071324 | 4,7 | 10000 |
| 2,0 | 821225 | 3,9 | 10000 |
| 3,0 | 722259 | 3,2 | 15000 |
| 5,0 | 560259 | 3,8 | 7000 |

### Beispiel 3: Einfluß der Reglerkonzentration (Ethylmercaptoacetat) auf M_{w} und D des Feststoffs

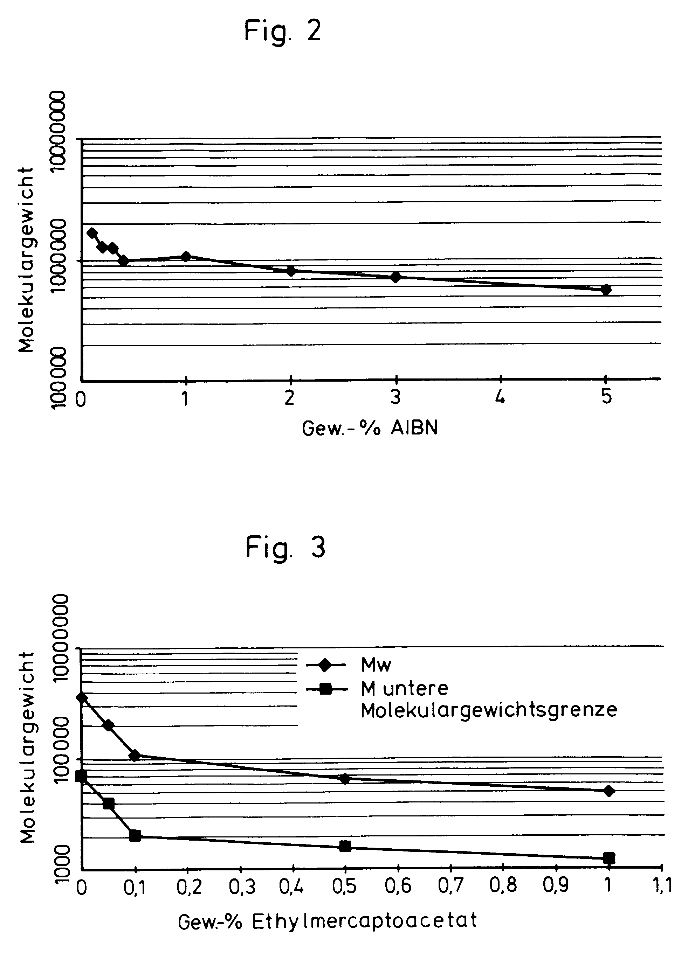

MMA wurde wie in Beispiel 1 beschrieben mit o,2 Gew.-% des Initiators AIBN und verschiedenen Konzentrationen des Reglers Ethylmercaptoacetat polymerisiert. Die Ergebnisse sind in Fig. 3 dargestellt. Mit sehr geringen Reglerkonzentrationen ( deutlich unterhalb 0,05 Gew.-%) kann die untere Molekulargewichtsgrenze oberhalb 30000 bei einer Dispersität zwischen 2 und 3 gehalten werden. Bei höheren Reglerkonzentrationen sinkt insbesondere die untere Molekulargewichtsgrenze sehr stark ab.

### Beispiel 4: Einfluß der Reglerkonzentration (t-Butylmercaptan) auf M_{w} und D des Feststoffs

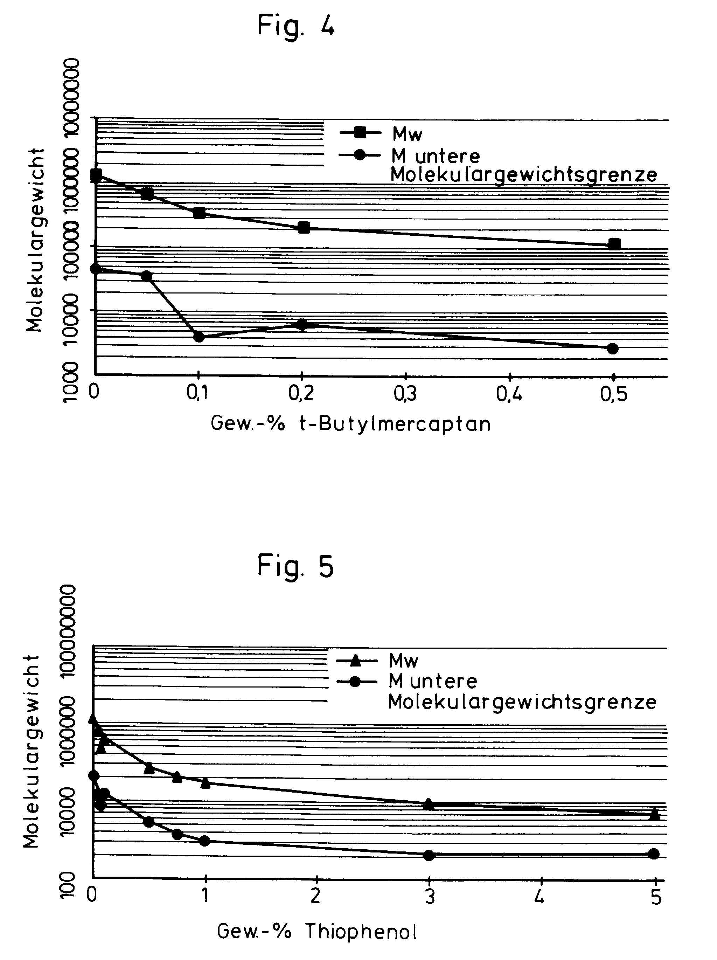

T-Butylmercaptan hat eine kleinere Übertragungskonstante als Ethylmercaptoacetat. Dies wird deutlich an den im Vergleich zu Ethylmercaptoacetat höheren Gewichtsmittelwerten bei vergleichbarer Konzentration, wie aus Fig. 4 hervorgeht. Auch in diesem Fall wird mit steigender Reglerkonzentration die Dispersität und das mittlere Molekulargewicht verringert. Von Interesse für die Herstellung eines Gießharzes für die Röntgentiefenlithographie ist das Polymerisat, das mit 0,05 Gew.-% t-Butylmercaptan und 0,2 Gew.-% AIBN polymerisiert wurde. Das Polymerisat besitzt mit ca. 36000 eine relativ hohe untere Molekulargewichtsgrenze verglichen mit dem bekannten Plexit M60^{R}, dessen untere Molekulargewichtsgrenze bei ca. 5000 liegt. Außerdem ist das Gewichtsmittel des Polymerisats mit 642400 noch nicht zu hoch und der Dispersitätswert ist mit 1.87 sehr klein.

### Beispiel 5: Einfluß der Reglerkonzentration (Thiophenol) auf M_{w} und D des Feststoffs

Der Feststoff wurde wiederum gemäß Beispiel 1 mit verschiedenen Thiophenol-Konzentrationen hergestellt. Die Ergebnisse sind in Fig. 5 dargestellt. Wie auch mit den Reglern Ethylmercaptoacetat und t-Butylmercaptan sinkt der M_{w}-Wert drastisch mit der Reglerkonzentration ab. Die Dispersität wird dagegen nur geringfügig beeinflußt. Die untere Molekulargewichtsgrenze überschreitet auch für geringe Thiophenol-Konzentrationen den Wert von 15000 nicht.

### Vergleich der Versuchsergebnisse bezüglich der Art und Konzentration der verschiedenen Regler bei der Herstellung des Feststoffs

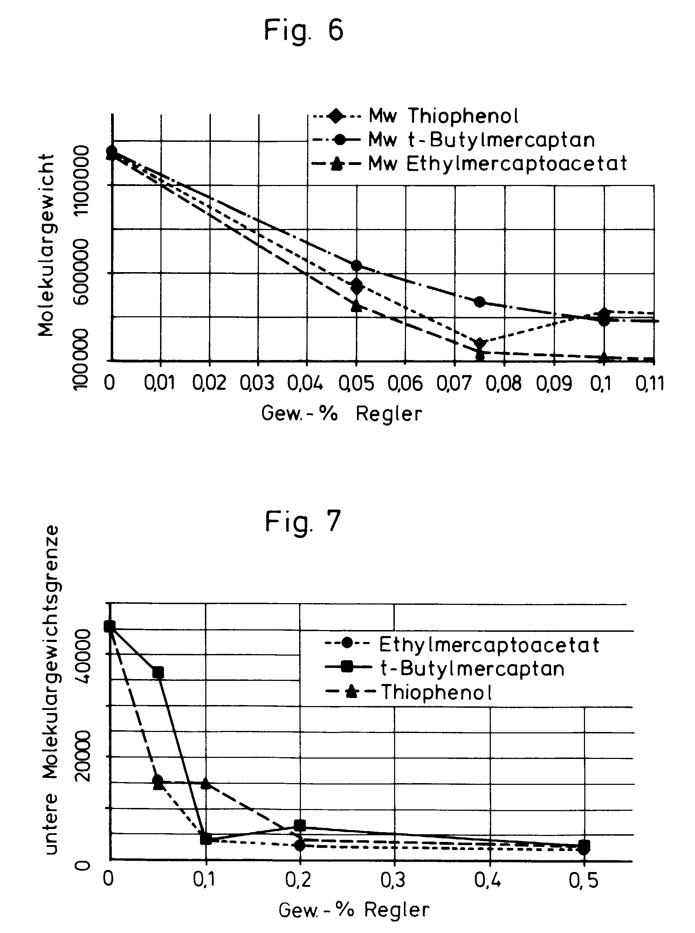

In Fig. 6 sind die Gewichtsmittel und in Fig. 7 die unteren Molekulargewichtsgrenzen als Funktion der verschiedenen Regler-Konzentrationen dargestellt. Die besten Ergebnisse liefert der mit 0,2 Gew.-% AIBN und 0,5 Gew.-% t-Butylmercaptan hergestellte Feststoff, der eine hohe untere Molekulargewichtsgrenze (36400) bei geringer Dispersität (1.87) und einem nur mäßig hohen mittleren Molekulargewicht (642400) aufweist. Die untere Molekulargewichtsgrenze ist ohne Reglerzusatz höher (45200); ebenso sind jedoch das mittlere Molekulargewicht (1287600) und die Dispersität (2,56) erhöht.

### Beispiel 6: Darstellung und Eigenschaften des Gießharzes

Mit verschiedenen PMMA-Feststoffen wurden Gießharze durch Auflösen des Feststoffs in MMA dargestellt, um daraus Röntgenresistschichten herzustellen, deren Molekulargewichtsverteilung mit der des Polymerisats von Plexit M60^{R} verglichen werden kann. Die Viskosität wurde dabei so eingestellt, daß sie vergleichbar mit der von Plexit M60^{R} ist. In Tabelle 2 sind die Polymerisationsbedingungen, die mittleren Molekulargewichte und die Dispersitäten für die Feststoffanteile sowie die Verdünnungsverhältnisse zusammengestellt.

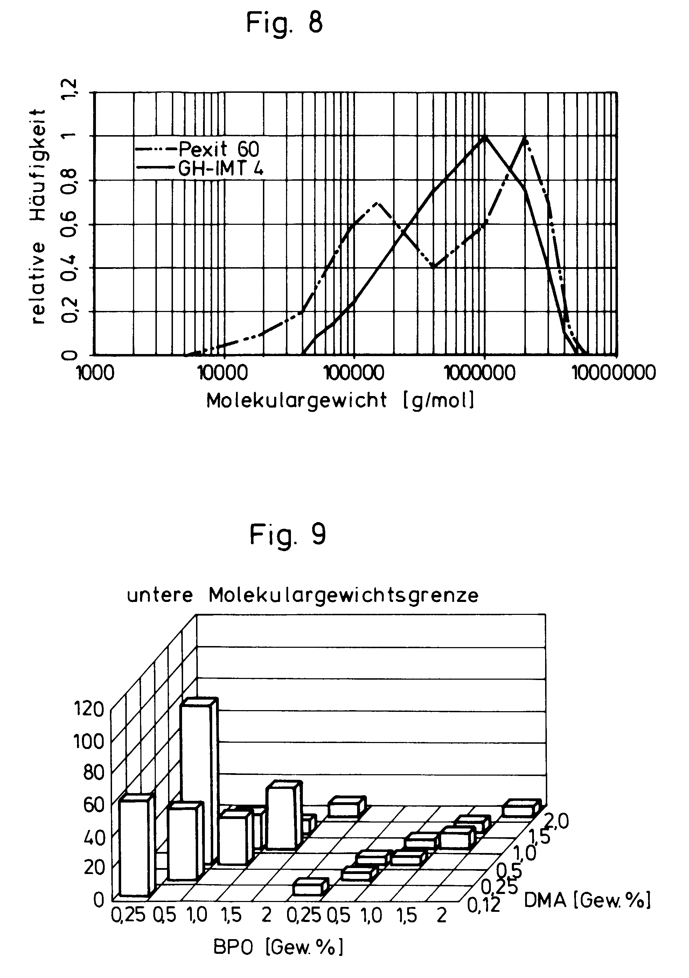

Die Ergebnisse der anschließenden Kalthärtung mit 1,5 Gew.-% BPO und 1 Gew.-% DMA sind in Tabelle 3 wiedergegeben. Die Verteilungen sind alle bis auf die von GH-IMT 4 und GH-IMT 5 bimodal. Die Gießharze GH-IMT 1 bis 3 stellen Vergleichsbeispiele dar und sind nicht Gegenstand der Erfindung. Besonders interessant ist das als GH-IMT 4 bezeichnete Gießharz. Bei der Kalthärtung von GH-IMT 4 entsteht ein Polymerisat mit einem M_{w}-Wert von ca. 600000 und einer Dispersität von 1,88. GH-IMT 4 besitzt den selben M_{w}-Wert wie Plexit M60^{R}, jedoch ist die Molekulargewichtsverteilung bedeutend enger. Die niedermolekularen Anteile sind wesentlich geringer als bei Plexit M60^{R}, wie ein Vergleich der beiden Verteilungen zeigt (Fig. 8).

Bei Bestrahlungsversuchen mit GH-IMT 4 zeigte sich eine deutliche Verminderung der nicht löslichen Anteile.

**Tabelle 2:**

| Polymerisationsbedingungen, M_{w} und D der Feststoffanteile, die zur Gießharzdarstellung eingesetzt wurden | | | | |
|---|---|---|---|---|
| Bezeichnung | Polymerisationsbedingungen für den Feststoff | M_{W} | D | Verhältnis PMMA/MMA |
| GH-IMT 1 | 0,2 Gew.-% AIBN | 1287600 | 2,56 | 8:92 |
| GH-IMT 2 | 0,2 Gew.-% AIBN | 421865 | 2,15 | 20:80 |
| | 0,5 Gew.-% "1" | | | |
| GH-IMT 3 | 0,4 Gew.-% AIBN | 21749 | 1,77 | 35:65 |
| | 1,0 Gew.-% "1" | | | |
| GH-IMT 4 | 0,2 Gew.-% AIBN | 642437 | 1,87 | 16:84 |
| | 0,05 Gew.-% "2" | | | |
| GH-IMT 5 | 0,2 Gew.-% AIBN | 333613 | 1,87 | 18:82 |
| | 0,1 Gew.-% "2" | | | |

| | | | | |
|---|---|---|---|---|
| "1": Ethylmercaptoacetat | | | | |
| "2": t-Butylmercaptan | | | | |

**Tabelle 3:**

| Charakteristische Werte der Molekulargewichtsverteilung bei Kalthärtung der Gießharze | | | |
|---|---|---|---|
| Feststoff | M_{W} des hinzupolymeripolymerisierten Anteils | D | untere Molekulargewichtsgrenze |
| Plexit M60^{R} | 1300000 | 6,0 | 5500 |
| GH-IMT 1 | 150000 | 5,88 | 11600 |
| GH-IMT 2 | 200000 | 2,7 | 14000 |
| GH-IMT 3 | 350000 | 6,3 | 2500 |
| GH-IMT 4 | 622037 | 1,88 | 40000 |
| GH-IMT 5 | 309687 | 1,73 | 15000 |

### Beispiel 7: Variationen des BPO- und des DMA-Anteils bei der Herstellung des Röntgenresists

Am Beispiel von Plexit M60^{R} und GH-IMT 4 wurde untersucht, wie sich die Molekulargewichtsverteilung ändert, wenn der Initiator (BPO)- und Aktivator (DMA)-Anteil variiert wird. Eine Tabellarische Zusammenfassung findet sich in Tabelle 4. In Fig. 9 ist die untere Molekulargewichtsgrenze für Plexit M60^{R} und GH-IMT 4 als Funktion der Konzentrationen von BPO und DMA dargestellt.

Eine Erniedrigung der BPO- und der DMA-Konzentrationen bewirkt eine Erhöhung der M_{w}-Werte, aber im Fall von Plexit M60^{R} auch eine Erhöhung der Dispersitäten. Die niedermolekularen Anteile im Plexit M60^{R} bleiben wie erwartet unverändert. Im Gegensatz dazu bewirkt eine Erniedrigung der BPO- und DMA-Konzentrationen für das GH-IMT 4 sowohl eine Erhöhung der M_{w}-Werte als auch der niedermolekularen Grenze. Die Dispersitäten bleiben relativ unverändert. Dies läßt sich damit erklären, daß bei Plexit M60^{R} die niedermolekulare Grenze im wesentlichen vom Feststoffanteil im Gießharz, für den diese nur etwa 5000 beträgt, bestimmt wird. Beim GH-IMT 4 dagegen, bei dem die untere Molekulargewichtsgrenze größer als 40000 ist, wird die untere Molekulargewichtsgrenze der Resistschicht von der Polymerisation des Gießharzes bestimmt.

Bei BPO- und DMA-Konzentrationen von 0,5 und 0,5 Gew.-% bzw von 0,25 und 0,12 Gew.-% wird die niedermolekulare Grenze jeweils am stärksten erhöht.

**Tabelle 4:**

| Einfluß der BPO- und DMA-Konzentrationen auf den M_{w}-Wert, die Dispersität und die untere Molekulargewichtsgrenze für Plexit M60^{R} und GH-IMT 4 | | | |
|---|---|---|---|
| BPO; DMA Anteile in Gew.-% | M_{w} | untere Molekulargewichtsgrenze | Dispersität |
| a) Plexit M60^{R} | | | |
| 2; 2 | 390000 | 6600 | 4,1 |
| 1,5; 1,5 | 470000 | 6350 | 4,8 |
| 1; 1 | 715000 | 5760 | 6,0 |
| 0,5; 0,5 | 985000 | 4560 | 9,6 |
| 1,5; 1,0 | 625000 | 9500 | 4,7 |
| 1,0; 0,5 | 802000 | 5200 | 8,7 |
| 0,5; 0,25 | 1120000 | 4800 | 10,6 |
| 0,25; 0,12 | 1546000 | 7200 | 11,9 |

| b) GH-IMT 4 | | | |
|---|---|---|---|
| 2; 2 | 533000 | 8200 | 4,1 |
| 1,5; 1,5 | 642000 | 6860 | 4,4 |
| 1; 1 | 828000 | 21600 | 2,8 |
| 0,5; 0,5 | 1100000 | 100000 | 2,7 |
| 1,5; 1,0 | 622037 | 40000 | 1,88 |
| 1,0; 0,5 | 869000 | 30000 | 5,4 |
| 0,5; 0,25 | 1092000 | 45000 | 2,4 |
| 0,25; 0,12 | 1120000 | 60000 | 2,8 |

## Patentansprüche

1. Verwendung eines Gießharzes bestehend aus 65 bis 95 Gew.-% Methylmethacrylat (MMA) mit einem gelösten Feststoffanteil von 5 bis 35 Gew.-% Polymethylmethacrylat (PMMA), dessen untere Molekulargewichtsgrenze mindestens 30000 beträgt und dessen Gewichtsmittel M_{w} 1,3 · 10⁶ nicht übersteigt, zur Herstellung eines Positiv-Röntgenresists.

2. Verwendung gemäß Anspruch 1, dadurch gekennzeichnet, daß die untere Molekulargewichtsgrenze mindestens 40000 beträgt.

3. Verwendung gemäß Anspruch 1, dadurch gekennzeichnet, daß die Dispersität des Feststoffanteils unter 3 liegt.

4. Verfahren zur Herstellung eines Röntgenresists, bei dem
a) ein Feststoff bestehend aus Polymethylmethacrylat (PMMA) hergestellt wird, indem Methylmethacrylat (MMA) mit einem Initiator und einem Regler polymerisiert wird,
b) der Feststoff unter Bildung eines Gießharzes in MMA aufgelöst wird,
c) das Gießharz in Schichtform in an sich bekannter Weise polymerisiert wird,
dadurch gekennzeichnet, daß
d) die untere Molekulargewichtsgrenze der hergestellten PMMA mindestens 30000 beträgt und ein Gewichtsmittel von 1,3 · 10⁶ nicht übersteigt und daß
e) als Initiator Azodiisobuttersäuredinitril (AIBN) in einer Konzentration von 0,2 bis 0,4 Gew.-% und als Regler ein Mercaptan oder ein nichtaromatisches Mercaptan-Derivat in einer Konzentration unter 0,1 Gew.-% ein-gesetzt werden.

5. Verfahren nach Anspruch 4, dadurch gekennzeichnet, daß das Mercaptan t-Butylmercaptan darstellt.

6. Verfahren nach Anspruch 5, dadurch gekennzeichnet, daß das t-Butylmercaptan in einer Konzentration von 0,05 Gew.-% eingesetzt wird.

7. Verfahren nach Anspruch 4, dadurch gekennzeichnet, daß das gemäß Schritt b) durch Auflösen des Feststoffes in MMA hergestellt Gießharz mit Benzoylperoxid (BPO) als weiterem Initiator und Dimethylanilin (DMA) als Aktivator in einer Konzentration von jeweils 0,1 bis 2,0 Gew.-% polymerisiert wird.

## Claims

1. Use of a casting resin, comprising between 65 and 95 % by wt. methylmethacrylate (MMA) with a dissolved solids content of between 5 and 35 % by wt. polymethylmethacrylate (PMMA), the lower molecular weight limit of which is at least 30000, and the weight average M_{w} of which does not exceed 1.3 · 10⁶, for producing a positive radiographic resist.

2. Use according to claim 1, characterised in that the lower molecular weight limit is at least 40000.

3. Use according to claim 1, characterised in that the dispersion of the solids content is less than 3.

4. Method of producing a radiographic resist, wherein
a) a solid, comprising polymethylmethacrylate (PMMA), is produced by polymerising methylmethacrylate (MMA) with an initiator and a regulator,
b) the solid is dissolved in MMA to form a casting resin,
c) the casting resin is polymerised in layers in a manner known per se,
characterised in that
d) the lower molecular weight limit of the PMMA produced is at least 30000, and a weight average does not exceed 1.3 · 10⁶, and in that
e) azodiisobutyric acid dinitrile (AIBN) is used as the initiator in a concentration of between 0.2 and 0.4 % by wt., and a mercaptan or a non-aromatic mercaptan derivative is used as the regulator in a concentration of less than 0.1 % by wt.

5. Method according to claim 4, characterised in that the mercaptan represents t-butylmercaptan.

6. Method according to claim 5, characterised in that the t-butylmercaptan is used in a concentration of 0.05 % by wt.

7. Method according to claim 4, characterised in that the casting resin, produced according to step b) by dissolving the solid in MMA, is polymerised with benzoyl peroxide (BPO) as an additional initiator and with dimethyl aniline (DMA) as the activator in a concentration of between 0.1 and 2.0 % by wt in each case.

## Revendications

1. Utilisation d'une résine de coulée constituée de 65 à 95 % en poids de méthacrylate de méthyle (MMA) avec une teneur en solide dissous de 5 à 35 % en poids de poly(méthacrylate de méthyle) (PMMA) dont la limite inférieure de poids moléculaire est au moins 30 000 et dont la moyenne de poids M_{w} ne dépasse pas 1,3.10⁶, pour produire un résiste de rayons X positif.

2. Utilisation selon la revendication 1,
caractérisée en ce que
la limite inférieure de poids moléculaire est au moins 40 000.

3. Utilisation selon la revendication 1,
caractérisée en ce que
la dispersion de la fraction de solide est inférieure à 3.

4. Procédé de préparation d'un résiste de rayons X, dans lequel :
a) on prépare un solide constitué de poly(méthacrylate de méthyle (PMMA), en polymérisant du méthacrylate de méthyle (MMA) avec un initiateur et un régulateur,
b) on dissout le solide dans le MMA en formant une résine de coulée,
c) on polymérise de la manière déjà connue la résine de coulée sous forme de couche,
caractérisé en ce que
d) la limite inférieure de poids moléculaire du PMMA préparé représente au moins 30 000 et ne dépasse pas une moyenne en poids de 1,3.10⁶ et que,
e) on utilise comme initiateur l'azodiisobutyrodinitrile (AIBN) en une concentration de 0,2 à 0,4 % en poids et comme régulateur un mercaptan ou un dérivé de mercaptan non-aromatique en une concentration inférieure à 0,1 % en poids.

5. Procédé selon la revendication 4,
caractérisé en ce que
le mercaptan est le t-butylmercaptan.

6. Procédé selon la revendication 5,
caractérisé en ce qu'
on utilise le t-butylmercaptan en une concentration de 0,05 % en poids.

7. Procédé selon la revendication 4,
caractérisé en ce qu'
on polymérise la résine de coulée préparée selon l'étape b) par dissolution du solide dans le MMA avec du peroxyde de benzoyle (BPO) comme autre initiateur et la diméthylaniline (DMA) comme activateur en une concentration de respectivement 0,1 à 2,0 % en poids.
